(19) Europäisches Patentamt / European Patent Office / Office européen des brevets

(11) **EP 4 694 655 A1**

(12) **EUROPEAN PATENT APPLICATION**
published in accordance with Art. 153(4) EPC

(43) Date of publication:
**11.02.2026 Bulletin 2026/07**

(21) Application number: **24779805.1**

(22) Date of filing: **21.03.2024**

(51) International Patent Classification (IPC):
*H10N 30/30* (2023.01)    *G01L 1/16* (2006.01)

(52) Cooperative Patent Classification (CPC):
**H10N 30/302; G01L 1/16; H10N 30/06;
H10N 30/857; H10N 30/878**

(86) International application number:
**PCT/JP2024/010929**

(87) International publication number:
**WO 2024/203682 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **24.03.2023 JP 2023048026**

(71) Applicant: **Kureha Corporation
Chuo-ku
Tokyo 103-8552 (JP)**

(72) Inventors:
• **IMAJI, Makoto
  Tokyo 103-8552 (JP)**
• **TSUDA, Takuya
  Tokyo 103-8552 (JP)**

(74) Representative: **Hoefer & Partner Patentanwälte
mbB
Pilgersheimer Straße 20
81543 München (DE)**

(54) **LAMINATED PIEZOELECTRIC BODY, TOUCH PANEL, AND METHOD FOR MANUFACTURING LAMINATED PIEZOELECTRIC BODY**

(57)    A laminated piezoelectric body includes: a piezoelectric film containing, as a main component, a fluorine-based resin and having a piezoelectric constant $d_{33}$ of 7 pC/N or more and 40 pC/N or less; a charge dispersion layer disposed on at least one surface of the piezoelectric film, the charge dispersion layer having a surface resistivity of $1.0 \times 10^4$ Ω/sq. or more and $1.0 \times 10^{12}$ Ω/sq. or less; a transparent electrode; and a transparent adhesive layer disposed between the transparent electrode and the charge dispersion layer. The laminated piezoelectric body has a total light transmittance of 80% or more.

[FIG. 1]

Description

## TECHNICAL FIELD

The present invention relates to a laminated piezoelectric body, a touch panel, and a method for manufacturing the laminated piezoelectric body.

## BACKGROUND ART

In general, a touch panel detects a two-dimensional position on the surface of the touch panel when a finger, a pen, or the like, touches the surface of the touch panel. When inputting into the touch panel, to avoid the input to be misrecognized, the selection and the execution are desirably kept separate. To be more specific, it is desirable to select a two-dimensional position on the touch surface and execute the selected by applying pressure to the touch surface. Therefore, applying a pressure-sensitive sensor that detects pressure on a touch surface to a touch panel has been under consideration.

As the pressure-sensitive sensor, application of a piezoelectric film that generates a voltage in response to pressing has been proposed. As the piezoelectric film, a piezoelectric film using a polymer material such as a fluorine-based resin and polylactic acid is known (for example, see Patent Documents 1 and 2).

To apply these piezoelectric films to a touch panel, it is preferred to directly dispose indium tin oxide (ITO) as a transparent electrode on the piezoelectric film. To form a transparent electrode by using ITO, an ITO film is formed on a substrate, and then the crystallinity of ITO is increased by heat treatment, whereby the resistance value of the transparent electrode can be reduced and the transparency can be increased. When the substrate is a glass substrate, it is heat-treated (annealed) at several hundred degrees, and when the substrate is a polyethylene terephthalate (PET), it is heat-treated (annealed) at 140 to 150°C. In a case where an ITO film is formed on a piezoelectric film containing a fluorine-based resin, there has been an issue that the color tone is likely to change when the film is treated at a high temperature as described above, and therefore, high transparency is hard to maintain.

In contrast, Patent Documents 3 and 4 each disclose a transparent piezoelectric sheet in which a piezoelectric film and a transparent electrode film are laminated through a transparent adhesive layer. Patent Document 4 states that, even when a transparent electrode is disposed on a piezoelectric film through a transparent adhesive layer, not only can a touch pressure be detected, but also an existing transparent electrode film can be used, and therefore, high transparency is hard to maintain.

## CITATION LIST

### PATENT DOCUMENT

Patent Document 1: WO 2016/098597
Patent Document 2: JP 2011-006596 A
Patent Document 3: WO 2020/152464
Patent Document 4: JP 2011-222679A

## SUMMARY OF INVENTION

### TECHNICAL PROBLEM

However, the studies conducted by the present inventors have found that, in a case where a laminated piezoelectric body in which a transparent electrode film is laminated on a piezoelectric film containing a fluorine-based resin through a transparent adhesive layer is used as a pressure-sensitive sensor as described in Patent Document 4, there is an issue that the signal intensity is weak.

When the signal intensity is weak, the electric signal generated by the pressure sensing is likely to be buried in noises, and the SN ratio is likely to be low. Therefore, there has been an issue that the pressing cannot be detected with high sensitivity.

The present invention has been made in view of the above-described circumstances, and an object thereof is to provide: a laminated piezoelectric body that can detect pressing with high sensitivity while maintaining transparency; a touch panel; and a method for manufacturing the laminated piezoelectric body.

**SOLUTION TO PROBLEM**

[1] A laminated piezoelectric body, including: a piezoelectric film containing, as a main component, a fluorine-based resin and having a piezoelectric constant $d_{33}$ of 7 pC/N or more and 40 pC/N or less; a charge dispersion layer disposed on at least one surface of the piezoelectric film, the charge dispersion layer having a surface resistivity of $1.0 \times 10^4 \, \Omega/\text{sq.}$ or more and $1.0 \times 10^{12} \, \Omega/\text{sq.}$ or less; a transparent electrode; and a transparent adhesive layer disposed between the transparent electrode and the charge dispersion layer, wherein the laminated piezoelectric body has a total light transmittance of 80% or more.
[2] The laminated piezoelectric body according to [1], wherein a thickness of the charge dispersion layer is 10 nm or more and 1000 nm or less.
[3] The laminated piezoelectric body according to [1] or [2], wherein the fluorine-based resin is a polymer containing, as a main component, a structural unit derived from vinylidene fluoride.
[4] The laminated piezoelectric body according to [3], wherein the fluorine-based resin is a homopolymer of vinylidene fluoride.
[5] The laminated piezoelectric body according to any of [1] to [4], wherein a thickness of the transparent adhesive layer is 10 $\mu$m or more and 100 $\mu$m or less.
[6] The laminated piezoelectric body according to any of [1] to [5], wherein a thickness of the piezoelectric film is 25 $\mu$m or more and 120 $\mu$m or less.
[7] A touch panel, including the laminated piezoelectric body described in any of [1] to [6].
[8] A method for manufacturing the laminated piezoelectric body described in any of [1] to [6], the method including: preparing the piezoelectric film; forming, on at least one surface of the piezoelectric film, the charge dispersion layer by applying a composition for a charge dispersion layer; and bonding the charge dispersion layer of the laminate and a transparent electrode through the transparent adhesive layer.
[9] The method for manufacturing the laminated piezoelectric body according to [8], wherein, in preparing the piezoelectric film, a film containing, as a main component, a fluorine-based resin is stretched and then subjected to polarization treatment.

**ADVANTAGEOUS EFFECTS OF INVENTION**

The present invention provides: a laminated piezoelectric body that can detect pressing with high sensitivity while maintaining transparency; a touch panel; and a method for manufacturing the laminated piezoelectric body.

**BRIEF DESCRIPTION OF THE DRAWINGS**

FIG. 1 is a schematic cross-sectional view illustrating a configuration of the laminated piezoelectric body according to the present embodiment.
FIG. 2 is a schematic cross-sectional view illustrating the laminated piezoelectric body according to an alternative example.

**DESCRIPTION OF EMBODIMENTS**

As described above, the reason for the weak signal intensity of the laminated piezoelectric body in which the piezoelectric film containing, as a main component, a fluorine-based resin and the transparent electrode film are laminated through the transparent adhesive layer is assumed to be as follows.
The polarization behavior that occurs when pressure is applied varies depending on the type of resin. For example, polylactic acid causes the polarization of a piezoelectric constant $d_{14}$ to occur. That is, when pressure is applied to a piezoelectric film containing polylactic acid in the direction perpendicular to the film surface, polarization occurs in the direction perpendicular to the shear plane due to the shear stress generated by the deflection of the film caused by the pressure. Therefore, the charge polarized on the film surface is not necessarily restricted only on the pressed range of the film, but is likely to be polarized in a relatively wide range on the film surface.
On the other hand, the fluorine-based resin mainly has piezoelectricity of a piezoelectric constant $d_{33}$. The piezoelectric constant $d_{33}$ indicates that the polarization occurs in the three-axis direction when stress is applied in the three-axis direction (z-axis direction). That is, when pressure is applied to a piezoelectric film containing a fluorine-based resin in the direction perpendicular to the film surface (three-axis direction), the polarization of charge occurs in the perpendicular direction (three-axis direction). Therefore, the polarization of charge is likely to occur locally in the pressed range of the film surface, whereby the charge density of the pressed area becomes very high. In this area, there is a possibility that the increase in the charge density in response to the stress becomes saturated. Therefore, when the charge density is in a saturated state, the charge is not sufficiently induced to the electrode on the side opposite to the piezoelectric film through the transparent adhesive layer, whereby the signal intensity is likely to be weak.

Therefore, in the present invention, a charge dispersion layer is disposed on at least one surface of a piezoelectric film containing, as a main component, a fluorine-based resin. In this manner, even when an area having a high charge density is locally generated in the piezoelectric film, the charge can be dispersed in the charge dispersion layer and can be made uniform. Whereby, saturation of the charge density can be suppressed. In addition, even when the piezoelectric film and the transparent electrode film are laminated through the transparent adhesive layer, since the charge is sufficiently induced to the transparent electrode side, the signal intensity can be increased, whereby the detection sensitivity can be increased. Hereinafter, the laminated piezoelectric body and a method for manufacturing the laminated piezoelectric body according to an embodiment of the present invention will be described.

1. Laminated Piezoelectric Body

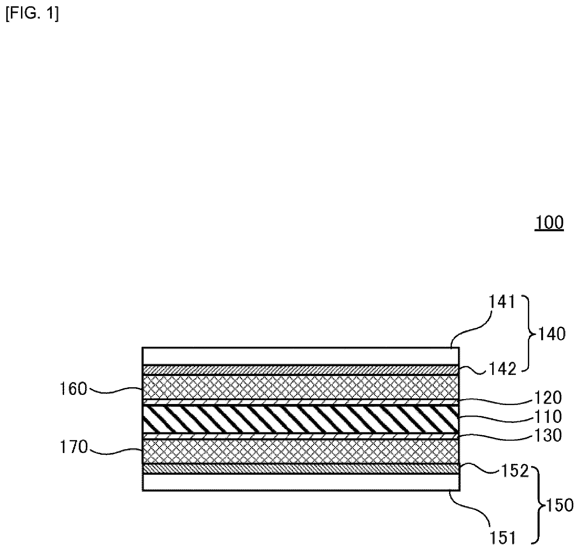

FIG. 1 is a schematic cross-sectional view illustrating a configuration of the laminated piezoelectric body 100 according to the present embodiment.

As illustrated in FIG. 1, a laminated piezoelectric body 100 according to the present embodiment includes a piezoelectric film 110, a first charge dispersion layer 120, a second charge dispersion layer 130, a first transparent electrode film 140, a second transparent electrode film 150, a first transparent adhesive layer 160, and a second transparent adhesive layer 170.

Hereinafter, in the present specification, the first charge dispersion layer 120 and the second charge dispersion layer 130 are also collectively referred to as a "charge dispersion layer"; the first transparent electrode film 140 and the second transparent electrode film 150 are also collectively referred to as a "transparent electrode film"; and the first transparent adhesive layer 160 and the second transparent adhesive layer 170 are also collectively referred to as a "transparent adhesive layer".

1-1. Piezoelectric Film 110

The piezoelectric film 110 contains a fluorine-based resin as a main component and has a piezoelectric constant $d_{33}$ adjusted to 7 pC/N or more and 40 pC/N or less. When $d_{33}$ of the piezoelectric film 110 is 7 pC/N or more, the piezoelectric film functions as a highly sensitive pressure-sensitive sensor because the amount of charge generated by pressing is sufficient. When the piezoelectric constant $d_{33}$ of the piezoelectric film is 40 pC/N or less, irregularities on the film surface generated by polarization treatment can be further reduced, and therefore, appearance defect can be reduced. From the same viewpoint, the piezoelectric constant $d_{33}$ of the piezoelectric film is more preferably 10 pC/N or more and 30 pC/N or less, and still more preferably 12 pC/N or more and 30 pC/N or less.

The piezoelectric constant $d_{33}$ is one of the indexes indicating the polarization behavior when a predetermined pressure is applied. As the piezoelectric constant $d_{33}$ is larger, the degree of polarization that is caused to occur when a predetermined pressure is applied becomes larger, and thus the charge density becomes larger.

The piezoelectric constant $d_{33}$ of the piezoelectric film 110 can be calculated by measuring the charge generated when a stress is applied in the thickness direction of the piezoelectric film at a predetermined rate, and the piezoelectric constant $d_{33}$ can be measured in accordance with ISO 19622:2018, which is a test method for the piezoelectric constant $d_{33}$ of piezoelectric ceramics by a direct quasi-static method ($d_{33}$ meter method; Berlincourt method). Specifically, a sample of the piezoelectric film is clipped at 1 N by using a piezoelectric constant measurement apparatus (for example, Piezometer System PM300 available from Piezotest Pte Ltd.), and the charge generated when a force of 0.15 N and 110 Hz is applied is read.

The piezoelectric constant $d_{33}$ of the piezoelectric film 110 can be adjusted mainly by the type of the resin contained in the piezoelectric film 110 and manufacturing conditions (conditions for the polarization treatment and the stretching treatment). For example, among fluorine-based resins, the piezoelectric constant $d_{33}$ of the piezoelectric film is likely to be increased as the resin contains more structural units derived from vinylidene fluoride. In addition, the piezoelectric constant $d_{33}$ of the piezoelectric film is likely to be increased by intensifying the polarization treatment or the stretching treatment.

As described above, the piezoelectric film 110 contains a fluorine-based resin as a main component. Containing, as a main component, a fluorine-based resin means that the content of a resin having a fluorine-based resin as a structural unit (including the fluorine-based resin itself) is 50 mass% or more in the total mass of the resin constituting the piezoelectric film. The content of the fluorine-based resin is preferably 60 mass% or more, and still more preferably 80% or more. The upper limit of the content is not particularly limited and may be 100 mass%, or 90 mass% or less.

Among fluorine-based resins, from the viewpoint of easily achieving a high piezoelectric effect, the fluorine-based resin is preferably a polymer containing, as a main component, a structural unit derived from vinylidene fluoride.

The content of the structural unit derived from vinylidene fluoride in the polymer containing, as a main component, a structural unit derived from vinylidene fluoride is preferably 50 mass% or more, more preferably 70 mass% or more, still more preferably 80 mass% or more, and particularly preferably 90 mass% or more, based on the total amount of the structural unit of the polymer. As the content is larger, a higher piezoelectric effect is likely to be achieved. The upper limit of the content is not particularly limited and may be 100 mass%, or 90 mass% or less.

The polymer may further contain a structural unit derived from a monomer copolymerizable with the vinylidene fluoride, as long as the effect of the present invention is not impaired. Examples of the monomer copolymerizable with the vinylidene fluoride include fluorine-containing monomers such as trifluoroethylene, tetrafluoroethylene, hexafluoropropylene, chlorotrifluoroethylene, and vinyl fluoride. Note that two or more types of these monomers may be contained.

Among these, the piezoelectric film is preferably a homopolymer of vinylidene fluoride from the viewpoint that the piezoelectric constant $d_{33}$ of the piezoelectric film is easily increased and the sensitivity of the pressure-sensitive sensor to which the piezoelectric film is applied is increased.

The thickness of the piezoelectric film 110 is, for example, preferably 25 μm or more and 120 μm or less. When the thickness of the piezoelectric film is 25 μm or more, the amount of charge generated by a piezoelectric effect is further increased, whereby the signal intensity is easily increased. The thickness of the piezoelectric film is more preferably 30 μm or more and still more preferably 35 μm or more. When the thickness of the piezoelectric film is 120 μm or less, the transparency of the piezoelectric film is less likely to be impaired, and the thickness is more preferably 100 μm or less and still more preferably 80 μm or less. From the same viewpoint, the thickness of the piezoelectric film is more preferably 35 μm or more and 80 μm or less.

1-2. First Charge Dispersion Layer 120 and Second Charge Dispersion Layer 130

First Charge Dispersion Layer 120

The first charge dispersion layer 120 is disposed on one surface of the piezoelectric film. The first charge dispersion layer 120 increases the mobility of the polarization charge locally generated by pressing on one surface of the piezoelectric film 110 in the charge dispersion layer, and thus saturation or counting loss that occurs at the time of detecting the polarization charge can be reduced, and the sensitivity of the piezoelectric sensor can be improved.

The first charge dispersion layer 120 has conductivity. One indicator of the conductivity includes surface resistivity. The surface resistivity of the first charge dispersion layer 120 is $1.0 \times 10^4$ Ω/sq. or more and $1.0 \times 10^{12}$ Ω/sq. or less. When the surface resistivity is $1.0 \times 10^{12}$ Ω/sq. or less, the first charge dispersion layer 120 has sufficient conductivity, and thus the charge generated by pressing in the pressed part of the piezoelectric film 110 easily moves in the charge dispersion layer, and when detecting the polarization charge, the polarization charge can be detected as a signal without saturation or counting loss. Thus, the signal intensity can be increased even in the laminated piezoelectric body having the transparent adhesive layer. On the other hand, when the surface resistivity is $1.0 \times 10^4$ Ω/sq. or more, the transparency of the first charge dispersion layer 120 is further less likely to be impaired. From the same viewpoint, the surface resistivity of the first charge dispersion layer 120 is more preferably $1.0 \times 10^4$ Ω/sq or more and $1.0 \times 10^9$ Ω/sq or less, and particularly preferably $1.0 \times 10^6$ Ω/sq or more and $1.0 \times 10^9$ Ω/sq or less. The surface resistivity can be measured in accordance with JIS K 6911 by using a known resistivity meter, for example.

The surface resistivity can be adjusted based on the thickness of the first charge dispersion layer 120, and the type and content of the conductive polymer or the conductive material contained in the first charge dispersion layer 120. For example, when the thickness of the first charge dispersion layer 120 is increased, the surface resistivity is decreased. In addition, when the content of the conductive polymer or the conductive material in the first charge dispersion layer 120 is increased, the surface resistivity is decreased.

The first charge dispersion layer 120 may be configured so that the surface resistivity is within the above-described range. The first charge dispersion layer 120 contains a conductive polymer or a conductive material other than the conductive polymer. In the present embodiment, the first charge dispersion layer 120 may contain a cured product of a curable composition containing a conductive polymer or a conductive material other than the conductive polymer, a polymerizable compound, and an optional curing agent.

Examples of the conductive polymer include polyacetylene or a derivative thereof, polythiophene or a derivative thereof, polypyrrole or a derivative thereof, polyaniline or a derivative thereof, polyphenylene or a derivative thereof, polyphenylene vinylene or a derivative thereof, polynaphthalene or a derivative thereof, polyacene or a derivative thereof, and the like. Among these, polythiophene or a derivative thereof is preferred from the viewpoint that the transparency is high and high conductivity is exhibited.

Examples of the conductive material include carbon nanotubes and graphene.

The polymerizable compound may be a thermally polymerizable compound or a photopolymerizable compound, and examples thereof include an acrylic compound, an epoxy compound, an oxetane compound, a polyurethane compound, a polyimide resin, a melamine resin, a silicone compound, and vinyl acetate.

The thickness of the first charge dispersion layer 120 may be within a range in which the charge generated in the piezoelectric film 110 can be dispersed, and is, for example, preferably 10 nm or more and 1000 nm or less. When the thickness of the first charge dispersion layer 120 is 10 nm or more, the polarization charge generated on the surface of the piezoelectric film 110 is allowed to move more easily in the charge dispersion layer, and saturation or counting loss that occurs at the time of detecting the polarization charge can be further reduced, whereby the signal intensity is further easily increased. When the thickness of the first charge dispersion layer 120 is 1000 nm or less, the color tone due to the conductive polymer or the like and the appearance defect due to the irregularities on the film surface of the piezoelectric film 110 are further less likely to occur, and the transparency is further less likely to be impaired. From the same viewpoint, the thickness of the first charge dispersion layer 120 is more preferably 20 nm or more and 800 nm or less, still more preferably 30 nm or more and 600 nm or less, and particularly preferably 40 nm or more and 400 nm or less.

Second Charge Dispersion Layer 130

The second charge dispersion layer 130 is disposed on the other surface of the piezoelectric film 110. In the piezoelectric film having the piezoelectric constant $d_{33}$, charge is polarized on both surfaces of the piezoelectric film in response to pressing. Therefore, the charge dispersion layer is preferably provided on both surfaces of the piezoelectric film. The second charge dispersion layer 130 increases the mobility of the polarization charge locally generated by pressing in the charge dispersion layer on the other surface of the piezoelectric film having the first charge dispersion layer provided thereon, and thus saturation or counting loss that occurs at the time of detecting the polarization charge can be reduced, and the sensitivity of the piezoelectric sensor can be improved as described above.

In the present embodiment, the second charge dispersion layer 130 has the same or similar configuration as that of the first charge dispersion layer 120 described above, and a detailed description thereof will be omitted. That is, the configuration, material, physical properties, and the like, of the second charge dispersion layer 130 are similar to the configuration, material, physical properties, and the like, of the first charge dispersion layer 120 described above.

The composition of the first charge dispersion layer 120 and the composition of the second charge dispersion layer 130 may be the same or different. The thickness of the first charge dispersion layer 120 and the thickness of the second charge dispersion layer 130 may be the same or different.

1-3. First Transparent Electrode Film 140 and Second Transparent Electrode Film 150

First Transparent Electrode Film 140

The first transparent electrode film 140 is disposed on the first charge dispersion layer 120 side with respect to the piezoelectric film 110. The first transparent electrode film 140 includes a substrate layer 141 and a first transparent electrode 142; and the first transparent electrode 142 detects the charge generated in the piezoelectric film 110 as an electric signal through the first charge dispersion layer 120.

The substrate layer 141 is a transparent resin layer for supporting the first transparent electrode 142. The transparent resin contained in the substrate layer 141 is preferably a material having heat resistance to withstand heat for crystallizing ITO or the like. Examples of such a transparent resin include polyester such as polyethylene terephthalate (PET). Among these, PET is preferred.

The thickness of the substrate layer 141 is not particularly limited, as long as it can support the first transparent electrode 142, and is preferably 2 μm or more and 300 μm or less, more preferably 10 μm or more and 200 μm or less, still more preferably 20 μm or more and 150 μm or less, and particularly preferably 30 μm or more and 130 μm or less.

The first transparent electrode 142 is disposed on a surface on the side of the first charge dispersion layer 120 of the substrate layer 141. As the first transparent electrode 142, for example, an inorganic electrode such as ITO (indium tin oxide) and tin oxide is preferred, and ITO is more preferred.

Second Transparent Electrode Film 150

The second transparent electrode film 150 is disposed on the side of the second charge dispersion layer 130 with respect to the piezoelectric film 110. The second transparent electrode film 150 includes a substrate layer 151 and a second transparent electrode 152; and the second transparent electrode 152 extracts the charge generated in the piezoelectric film 110 as an electric signal through the second charge dispersion layer 130.

In the present embodiment, the second transparent electrode film 150 has a configuration similar to that of the first transparent electrode film 140 described above. That is, the configuration, material, and physical properties of the second transparent electrode film 150 may be similar to the configuration, material, and physical properties of the first transparent electrode film 140 described above.

The composition of the first transparent electrode 142 constituting the first transparent electrode film 140 and the composition of the second transparent electrode 152 constituting the second transparent electrode film 150 may be the same or different.

1-4. First Transparent Adhesive Layer 160 and Second Transparent Adhesive Layer 170

First Transparent Adhesive Layer 160

The first transparent adhesive layer 160 is disposed between the first charge dispersion layer 120 and the first transparent electrode 142 and adheres the piezoelectric film 110, on which the first charge dispersion layer 120 is disposed, and the first transparent electrode 142.

The first transparent adhesive layer 160 is transparent and preferably has elasticity to such an extent that a pressing force can be transmitted to the piezoelectric film 110. Examples of the adhesive contained in the first transparent adhesive layer 160 include acrylic-based adhesives, rubber-based adhesives, silicone-based adhesives, polyester-based adhesives, polyurethane-based adhesives, polyamide-based adhesives, epoxy-based adhesives, vinyl alkyl ether-based adhesives, and fluorine-based adhesives. Among these, from the viewpoint of adhesiveness and elasticity, acrylic-based adhesives are preferred.

The thickness of the first transparent adhesive layer 160 is not particularly limited, but is preferably 10 $\mu$m or more and 100 $\mu$m or less, more preferably 15 $\mu$m or more and 80 $\mu$m or less, and still more preferably 20 $\mu$m or more and 60 $\mu$m or less. When the thickness of the first transparent adhesive layer is 10 $\mu$m or more, the first charge dispersion layer 120 and the first transparent electrode 142 are easily adhered to each other more satisfactorily. When the thickness of the first transparent adhesive layer 160 is 100 $\mu$m or less, preferably 60 $\mu$m or less, the amount of charge extracted from the first charge dispersion layer 120 is increased, whereby the signal intensity is easily increased.

Second Transparent Adhesive Layer 170

The second transparent adhesive layer 170 is disposed between the second charge dispersion layer 130 and the second transparent electrode 152 and adheres the piezoelectric film 110, on which the second charge dispersion layer 130 is disposed, and the second transparent electrode 152. The adhesive contained in the second transparent adhesive layer 170 is similar to the adhesive contained in the first transparent adhesive layer 160 described above. The adhesive contained in the second transparent adhesive layer 170 and the adhesive contained in the first transparent adhesive layer 160 may be the same or different.

1-5. Other Layers

The laminated piezoelectric body 100 may further include other layers in addition to the above-described layers, as long as the effect of the present invention is not impaired. For example, a hard coat layer may be further disposed between the first charge dispersion layer 120 and the first transparent adhesive layer 160 or between the second charge dispersion layer 130 and the second transparent adhesive layer 170.

The thickness of each layer constituting the laminated piezoelectric body 100 can be determined by measuring the thickness in a range including the center of the surface of the laminated piezoelectric body 100 at three or more points at 5 mm intervals by using a spectral interference-type thickness meter (for example, "Optical NanoGauge C13027-11" available from HAMAMATSU PHOTONICS K.K.) and calculating the arithmetic mean value thereof. The refractive indexes of the respective layers can be measured by the method described in JIS K7142, and the main materials constituting the respective layers may be specified to set the refractive indexes thereof. For example, the refractive index of the piezoelectric film containing PVDF may be set to 1.42, and the refractive index of the first charge dispersion layer 120 and the second charge dispersion layer 130 may be set to 1.50.

1-6. Physical Properties

The laminated piezoelectric body 100 has high transparency. The laminated piezoelectric body 100 preferably has a total light transmittance of, for example, 80% or more. The total light transmittance of the laminated piezoelectric body 100 can be measured by using a haze meter (for example, NDH7000SP II, available from NIPPON DENSHOKU INDUSTRIES CO., LTD.) based on the method described in JIS K 7361-1.

1-7. Action

In the laminated piezoelectric body 100 according to the above-described embodiment, when pressure is applied in the direction perpendicular to the surface of the piezoelectric film 110 (three-axis direction), polarization occurs in the three-axis direction, and the piezoelectric effect is exhibited. Thus, polarized charge is induced on the surface of the piezoelectric film 110, and a distribution of the charge density is generated on the surface of the piezoelectric film 110 due to the distribution of the pressure of pressing.

In the present embodiment, the first charge dispersion layer 120 and the second charge dispersion layer 130 are provided on the surface of the piezoelectric film 110. Thus, the distribution of the charge density locally generated on the surface of the piezoelectric film 110 can be eliminated and made uniform. Thus, pressing can be detected with high sensitivity, and therefore, when the laminated piezoelectric body is used as a pressure-sensitive sensor of a touch panel, the laminated piezoelectric body has high detection sensitivity to the pressing operation.

2. Method for Manufacturing Laminated Piezoelectric Body

The laminated piezoelectric body according to the present embodiment can be manufactured through: (1) a step of preparing a laminate including a piezoelectric film and a charge dispersion layer, and (2) a step of bonding the charge dispersion layer of the provided laminate and a transparent electrode of the transparent electrode film through the transparent adhesive layer. The piezoelectric film, the charge dispersion layer, the transparent adhesive layer, and the transparent electrode film are the above-described piezoelectric film, charge dispersion layer, transparent adhesive layer, and transparent electrode film, respectively.

(1) On the Step of Preparing Laminate

The laminate can be obtained through (1-1) a step of obtaining a piezoelectric film containing a fluorine-based resin and (1-2) a step of forming a charge dispersion layer on at least one surface of the obtained piezoelectric film.

(1-1) Step of Manufacturing Piezoelectric Film

The piezoelectric film can be obtained through subjecting a film containing a fluorine-based resin to a polarization treatment. The film containing a fluorine-based resin may be a stretched film or an unstretched film. In the present embodiment, from the viewpoint of allowing a high piezoelectric effect to be exhibited, it is preferred to stretch the film containing a fluorine-based resin and then subject the stretched film to the polarization treatment.

The film containing a fluorine-based resin can be manufactured by any known method such as a melt-extrusion method or a solution-casting method. Among them, the film containing a fluorine-based resin is preferably manufactured by a melt-extrusion method. In the melt-extrusion method, the fluorine-based resin and an optional additive can be heated and melted in a cylinder of an extruder and then extruded from a die to obtain a film.

The obtained film has a structure in which an $\alpha$-type crystal (the main chain has a helical structure), a $\beta$-type crystal (the main chain has a planar zigzag structure), and the like are mixed. The $\beta$-type crystal has a large polarization structure. When the film is stretched, the $\alpha$-type crystal can be converted into the $\beta$-type crystal. In the stretching, the film may be stretched, as necessary, to convert the fluorine-based resin into the $\beta$-type crystal.

The stretching method is not particularly limited, and the stretching can be performed by a known stretching method such as a tenter method and a drum method.

A stretching ratio is, for example, 3.0 times or more and 6.0 times or less. When the stretching ratio is 3.0 times or more, not only is it easy to adjust the thickness and strength of the film to appropriate ranges, but also polarization occurs more easily. When the stretching ratio is 3.0 times or more, dislocation reaction to the $\beta$-type crystals proceeds sufficiently, and not only is higher piezoelectricity likely to be exhibited but also transparency can be further enhanced. When the stretching ratio is 6.0 times or less, it is possible to further suppress breakage due to stretching.

The obtained stretched film is subjected to a polarization treatment. The polarization treatment can be performed by, for example, applying a direct voltage between a ground electrode and a needle-shaped electrode. The voltage only needs to be adjusted depending on the thickness of the stretched film, and may be, for example, 1 kV or more and 50 kV or less.

In the present embodiment, as described above, the piezoelectric film can be obtained by polarizing the stretched film.

(1-2) Step of Forming Charge Dispersion Layer

A curable composition containing, for example, the above-described conductive polymer or the conductive material is applied to the surface of the obtained piezoelectric film, and then the resulting material is dried and cured to form a charge dispersion layer.

The composition may further contain water or a solvent in addition to the components described above. Examples of the solvent include alcohol solvents such as methanol, ethanol, and isopropyl alcohol.

The coating method is not particularly limited, and may be any of a spin coating method, a gravure coating method, a die coating method, a bar coating method, a dip coating method, or the like.

The drying of the composition can be performed by heating the applied composition. The heating temperature is preferably a temperature equal to or higher than a temperature at which the solvent can be removed and equal to or lower than the thermal deformation temperature of the fluorine-based resin constituting the piezoelectric film, and can be set to, for example, 100°C or more and 150°C or less. The thermal deformation temperature can be measured in accordance with, for example, JIS K 7191-2:2015. The composition may be cured by photocuring or thermal curing. In the case where thermal curing is performed, drying and thermal curing may be performed at the same time.

(2) On the Step of Bonding

The charge dispersion layer of the laminate and a transparent electrode film are bonded through the transparent adhesive layer.

The bonding method is not particularly limited, and the transparent adhesive layer may be bonded to the charge dispersion layer of the laminate, and then the transparent adhesive layer and the transparent electrode film may be bonded to each other. The bonding is performed so that the transparent electrode of the transparent electrode film is on the transparent adhesive layer side.

The laminated piezoelectric body according to the present embodiment can be used for various uses. In particular, the laminated piezoelectric body according to the present embodiment can be preferably used as a pressure-sensitive sensor of a touch panel mounted on various electronic devices because the laminated piezoelectric body has high transparency and can detect pressing with high sensitivity.

3. Alternative Example

In the above-described embodiment, the charge dispersion layer is disposed on both surfaces of the piezoelectric film, but may be disposed on only one surface.

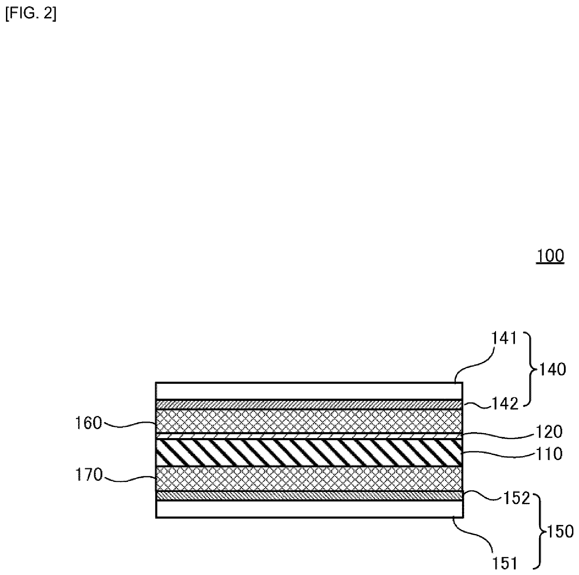

FIG. 2 is a schematic cross-sectional view illustrating the laminated piezoelectric body 100 according to a modified Example. As illustrated in FIG. 2, the laminated piezoelectric body 100 according to the modified Example may have the same configuration as that of the above-described embodiment except that the second charge dispersion layer 130 is omitted in the above-described embodiment. In addition, in a case where the laminated piezoelectric body 100 further has another layer, another layer may be further provided between the piezoelectric film 110 and the second transparent electrode 152.

**EXAMPLES**

Hereinafter, the present invention will be further described with reference to Examples and Comparative Examples. The technical scope of the present invention is not limited to these.

1. Evaluation of Physical Properties

(1) Thickness of Charge Dispersion Layer

The thickness of the charge dispersion layer formed on the piezoelectric film was measured by using a spectral interference-type thickness meter ("Optical NanoGauge C13027-11" available from HAMAMATSU PHOTONICS K.K.). Specifically, the thickness in a range including the center of the surface of the charge dispersion layer on the piezoelectric film was measured at 30 points with 5 mm intervals, and the arithmetic mean value was calculated. The refractive index of each layer was set for each material of each layer, and the refractive index of the piezoelectric film containing PVDF was set to 1.42 and the refractive index of the charge dispersion layer was set to 1.50.

(2) Surface Resistivity

The piezoelectric film having the charge dispersion layer formed thereon was cut into a size of 100 mm × 100 mm to obtain a sample film. The charge dispersion layer of the sample film was measured for its surface resistivity by using a surface resistance meter F-109 (available from HOZAN CO., LTD.) in accordance with JIS 6911. The measurement conditions were such that the value was read after 10 seconds at the power of 100 W.

(3) Piezoelectric Constant

Piezoelectric Constant $d_{33}$

The piezoelectric constant $d_{33}$ was measured in accordance with ISO 19622:2018, which is a test method for the piezoelectric constant $d_{33}$ of piezoelectric ceramics by a direct quasi-static method ($d_{33}$ meter method, Berlincourt method). Specifically, the piezoelectric constant $d_{33}$ of the piezoelectric film was measured by clipping the sample at 1 N and reading the charge generated when a force of 0.15 N and 110 Hz was applied by using a piezoelectric constant measurement device ("Piezometer System PM300" available from Piezotest Pte Ltd.). With regard to the actual measurement value of the piezoelectric constant $d_{33}$ of the piezoelectric film, the measurement temperature was 25°C, and the actual measurement value is a positive value or a negative value depending on whether the front or back side of the film is measured, but the absolute value is described in the present specification.

Piezoelectric Constant $d_{14}$

Al was vapor-deposited on both surfaces of the piezoelectric film, and the piezoelectric film was cut by 120 mm in a direction forming 45° with respect to the stretching direction (MD direction) of the piezoelectric film and 10 mm in a direction orthogonal to the direction forming 45° with respect to the stretching direction, whereby a rectangular film of 120 mm $\times$ 10 mm was cut out. This was used as a sample for measurement.
Next, the sample was set in a tensile tester with a chuck-to-chuck distance of 70 mm so as not to be slackened. Subsequently, a force was periodically applied to the sample at a rate of 5 mm/min so that the applied force alternated between 4 N and 9 N. In order to measure the amount of charge generated in the sample in accordance with the applied force, a capacitor having a capacitance Qm (F) was connected in parallel to the sample, and a voltage between terminals Vm of the capacitor Cm (95 nF) was measured through a buffer amplifier. The amount of generated charge Q (C) was calculated as the product of the capacitor capacitance Cm and the voltage between terminals Vm. The piezoelectric constant $d_{14}$ was calculated by the following formula.

$$d_{14} = (2 \times t)/L \times Cm \cdot \Delta Vm/\Delta F$$

t: Sample thickness (m)
L: Chuck-to-chuck distance (m)
Cm: Parallel-connected capacitor capacitance (F)
$\Delta Vm/\Delta F$: Ratio of the amount of change in voltage between the terminals of the capacitor to the amount of change in force

2. Production and Evaluation of Laminated Piezoelectric Body

Example 1

(1) Production of Piezoelectric Film

After stretching the polyvinylidene fluoride film (a film containing 100 mass% of a homopolymer of vinylidene fluoride, available from KUREHA CORPORATION) at a stretching ratio of 4.2 times in the MD direction, the film was subjected to polarization treatment by applying a DC voltage between a ground electrode and a needle-shaped electrode while increasing the DC voltage from 0 kV to 11.0 kV to obtain a piezoelectric film. Thus, a piezoelectric film having a thickness of 42 $\mu$m was obtained.

(2) Formation of Charge Dispersion Layer

A mixed solution of a liquid A of a coating material P-400MP-A (available from Nagase ChemteX Corporation) containing PEDOT: PSS as a conductive polymer and a liquid B of a coating material P-400MP-B (available from Nagase ChemteX Corporation) at a blending ratio of 4:1 was applied to the surface A of the obtained piezoelectric film with a gravure coater (multicoater available from HIRANO TECSEED Co., Ltd.), and the resulting material was heat-treated at 130°C for 1 minute to form a charge dispersion layer having a thickness of 50 nm.

(3) Formation of Transparent Adhesive Layer

Next, an optical clear adhesive (OCA) sheet (available from Nitto Denko Corporation; CS9862UA; thickness: 50 μm) was bonded to each of the charge dispersion layer formed on the surface A of the piezoelectric film and the surface B of the piezoelectric film.

(4) Production of Transparent Electrode Film

Next, a transparent electrode precursor film (TETOLIGHT TCF KH100NMH3-100-U8 available from OIKE & Co., Ltd.) obtained by subjecting the polyethylene terephthalate (PET) film to sputtering treatment with indium tin oxide (ITO) was subjected to crystallizing treatment at 150°C for 90 minutes to produce a transparent electrode film.

(5) Production of Laminated Piezoelectric Body

Then, the ITO surface of the transparent electrode film was bonded to each of the OCA sheet bonded to the charge dispersion layer on the surface A side of the piezoelectric film and the OCA sheet bonded to the surface B. A glass having a thickness of 1.1 mm was further bonded to the transparent electrode film on the surface A side of the piezoelectric film to produce a laminated piezoelectric body.

Example 2

A laminated piezoelectric body was obtained similarly to Example 1, except that the thickness of the charge dispersion layer was 130 nm.

Example 3

A charge dispersion layer having a thickness of 50 nm was formed on the surface A of the piezoelectric film by a method similar to Example 1. Thereafter, a coating material MT-3 (available from ARAKAWA CHEMICAL INDUSTRIES, LTD.) containing PEDOT: PSS was applied to the surface B of the piezoelectric film, which was then dried at 80°C, and was then irradiated with ultraviolet light in an integrated light quantity of 400 mJ/cm$^2$ by using a UV irradiator (CSOT-40 available from GS Yuasa Corporation) to form a charge dispersion layer having a thickness of 700 nm.
Then, an OCA sheet was bonded to each of the charge dispersion layers on the surface A and the surface B of the piezoelectric film, and a transparent electrode film was further bonded to each OCA sheet. A glass having a thickness of 1.1 mm was further bonded to the transparent electrode film on the surface A side of the piezoelectric film to obtain a laminated piezoelectric body.

Example 4

A laminated piezoelectric body was obtained similarly to Example 1, except that the thickness of the OCA sheet was 25 μm.

Example 5

A laminated piezoelectric body was obtained similarly to Example 1 except that the coating liquid A was changed to a coating material C-169PF-A (Nagase ChemteX Corporation) containing single-wall carbon nanotubes; the coating liquid B was changed to a coating material C-169PF-B (Nagase ChemteX Corporation); and the blending ratio of the liquid A and the liquid B was changed to 3;2.

Comparative Example 1

A laminated piezoelectric body was obtained similarly to Example 1 except that the charge dispersion layer was not formed.

Comparative Example 2

(1) Production of Piezoelectric Film

1.0 parts by mass of a stabilizer [a mixture of Stabaxol P400 (10 parts by mass) available from Rhein Chemie Rheinau GmbH, Stabaxol I (70 parts by mass) available from Rhein Chemie Rheinau GmbH, and CARBODILITE LA-1 (20 parts by mass) available from Nisshinbo Chemical Inc.], based on 100 parts by mass of polylactic acid available from NatureWorks LLC (product name: IngeoTM biopolymer), was added, and the mixture was dry-blended to adjust a raw material. This raw material was placed in a hopper of an extruder and was extruded from a T-die while being heated to 210°C, and the extruded material was then brought into contact with a cast roll at 50°C to form a pre-crystallized film having a thickness of 150 μm. The pre-crystallized film was uniaxially stretched in the MD direction by 3.5 times at 70°C by a roll-to-roll method to obtain a uniaxially stretched film. The thickness of the film was 49.2 μm. Next, the uniaxially stretched film was brought into contact with a roll at 145°C for 15 seconds by a roll-to-roll method and annealed, and was then rapidly cooled to produce a polylactic acid-based piezoelectric film.

(2) Formation of Antistatic Hard Coat Layer

An antistatic hard coat coating material (SEPLEGYDA (trade name) HC-A, available from Shin-Etsu Polymer Co., Ltd.) was applied on one surface of the obtained piezoelectric film with an applicator, and the resulting material was dried at 60°C for 5 minutes. Thereafter, the film was irradiated with ultraviolet light in an integrated light quantity of 1000 $mJ/cm^2$ with a metal halide lamp, thereby forming an antistatic hard coat layer on one surface of the piezoelectric film.

(3) Production of Laminated Piezoelectric Body

An OCA sheet was bonded to each of the film surface and the antistatic hard coat layer surface of the obtained piezoelectric film by the similar method as in Example 1, and then a transparent electrode film was bonded thereto. A glass having a thickness of 1.1 mm was further bonded to the transparent electrode film on the surface A side of the piezoelectric film to obtain a laminated piezoelectric body.

Evaluation

The total light transmittance and the pressing signal of the laminated piezoelectric body of each of Examples 1 to 5 and Comparative Examples 1 and 2 were evaluated by the following method.

Total Light Transmittance

The total light transmittance of the laminated piezoelectric body of each of Examples and Comparative Examples was measured by using a haze meter ("NDH7000SP II", available from NIPPON DENSHOKU INDUSTRIES CO., LTD.) based on the method described in JIS K 7361-1.

Detection of Pressing Signal

A laminated piezoelectric body having a vertical length of 171.7 mm and a lateral length of 233.5 mm was installed in a touch panel linearity evaluation system (available from Japan Novel Corporation) so that the stretching direction of the piezoelectric film was 1-axis and the thickness direction was three-axis, and the center of the glass surface of the laminated piezoelectric body was pushed in from the three-axis direction with the pressing terminals (diameter of the end: 3 mm) of a robot with a force of 8 N, and the signal intensity obtained at that time was measured.

For detection of the pressing signal, positive and negative lead wires were drawn from the terminals of the ITO electrodes of the laminated piezoelectric body and were connected to an amplifier. Then, the voltage signal amplified by the amplifier was converted into a digital signal through an AD converter and a filtering circuit, and the obtained digital signal was integrated to calculate the intensity of the piezoelectric signal.

The configuration and evaluation results of the laminated piezoelectric body of each of Examples 1 to 5 and Comparative Examples 1 and 2 are presented in Table 1.

[Table 1]

| | Piezoelectric film | | | First charge dispersion layer | | Second charge dispersion layer | | OCA | Laminated piezoelectric body | |
|---|---|---|---|---|---|---|---|---|---|---|
| | Type of substrate | Thickness /μm | Piezoelectric constant /pC/N | Surface Resistance Value/Ω | Thickness /nm | Surface Resistance Value/Ω | Thickness /nm | Thickness /μm | Total light transmittance/ % | Integrated signal intensity |
| Example 1 | PVDF | 42 | 14.0 | $1.2 \times 10^8$ | 50 | - | - | 50 | 88.3 | 23688 |
| Example 2 | PVDF | 42 | 14.0 | $1.1 \times 10^7$ | 130 | - | - | 50 | 85.6 | 26570 |
| Example 3 | PVDF | 42 | 14.0 | $1.2 \times 10^8$ | 50 | $3.4 \times 10^{10}$ | 700 | 50 | 87.3 | 42967 |
| Example 4 | PVDF | 42 | 14.0 | $1.2 \times 10^8$ | 50 | - | - | 25 | 88.3 | 39086 |
| Example 5 | PVDF | 42 | 14.0 | $7.1 \times 10^6$ | 50 | - | - | 50 | 88.3 | 29217 |
| Comparative Example 1 | PVDF | 42 | 14.0 | - | - | - | - | 50 | 88.5 | 20950 |
| Comparative Example 2 | PLA | 49 | 6.4 | $3.4 \times 10^{10}$ | 4000 | - | - | 50 | 85.2 | 5135 |

As indicated in Table 1, it is found that the laminated piezoelectric body of Comparative Example, 1 in which the charge dispersion layer was not provided on the piezoelectric film containing the fluorine-based resin, has a low signal intensity. In addition, it is found that the laminated piezoelectric body of Comparative Example 2 using the piezoelectric film containing polylactic acid has a low signal intensity even though the charge dispersion layer was provided.

In contrast, it is found that, in each of Examples 1 to 5 in which the charge dispersion layer is provided on at least one surface of the piezoelectric film containing a fluorine-based resin, the signal intensity is high while high transparency is maintained.

In particular, it is found that the signal intensity can be further increased by providing the charge dispersion layer on both surfaces of the piezoelectric film containing the fluorine-based resin (comparison between Examples 1 and 3).

It is also found that the signal intensity can be further increased by reducing the thickness of the transparent adhesive layer (comparison between Examples 1 and 4).

It is also found that the signal intensity can be further increased by setting the surface resistance value of the charge dispersion layer to $7.1 \times 10^6 \, \Omega$ (comparison between Examples 1 and 5).

The present application claims the benefit of and priority to Japanese Patent Application No. 2023-048026 filed on March 24, 2023. The contents described in the specification and drawings of this priority application are all incorporated in the specification of the present application by reference.

## INDUSTRIAL APPLICABILITY

According to the present invention, a laminated piezoelectric body that can detect pressing with high sensitivity while maintaining transparency and a touch panel can be provided. Therefore, the laminated piezoelectric body is suitable as a pressure-sensitive sensor of a touch panel.

## REFERENCE SIGNS LIST

100 Laminated piezoelectric body
110 Piezoelectric film
120 First charge dispersion layer
130 Second charge dispersion layer
140 First transparent electrode film
150 Second transparent electrode film
160 First transparent adhesive layer
170 Second transparent adhesive layer

## Claims

1. A laminated piezoelectric body, comprising:

   a piezoelectric film containing, as a main component, a fluorine-based resin and having a piezoelectric constant $d_{33}$ of 7 pC/N or more and 40 pC/N or less;
   a charge dispersion layer disposed on at least one surface of the piezoelectric film, the charge dispersion layer having a surface resistivity of $1.0 \times 10^4 \, \Omega/\text{sq.}$ or more and $1.0 \times 10^{12} \, \Omega/\text{sq.}$ or less;
   a transparent electrode; and
   a transparent adhesive layer disposed between the transparent electrode and the charge dispersion layer, wherein the laminated piezoelectric body has a total light transmittance of 80% or more.

2. The laminated piezoelectric body according to claim 1, wherein a thickness of the charge dispersion layer is 10 nm or more and 1000 nm or less.

3. The laminated piezoelectric body according to claim 1, wherein the fluorine-based resin is a polymer containing, as a main component, a structural unit derived from vinylidene fluoride.

4. The laminated piezoelectric body according to claim 3, wherein the fluorine-based resin is a homopolymer of vinylidene fluoride.

5. The laminated piezoelectric body according to claim 1, wherein a thickness of the transparent adhesive layer is 10 $\mu$m or more and 100 $\mu$m or less.

6. The laminated piezoelectric body according to claim 1, wherein a thickness of the piezoelectric film is 25 $\mu$m or more and 120 $\mu$m or less.

7. A touch panel, comprising the laminated piezoelectric body described in any one of claims 1 to 6.

8. A method for manufacturing the laminated piezoelectric body described in claim 1, the method comprising:

preparing the piezoelectric film;
forming, on at least one surface of the piezoelectric film, the charge dispersion layer by applying a composition for a charge dispersion layer; and
bonding the charge dispersion layer and the transparent electrode through a transparent adhesive layer.

9. The method for manufacturing the laminated piezoelectric body according to claim 8,
wherein, in preparing the piezoelectric film, a film containing, as a main component, a fluorine-based resin is stretched and then subjected to polarization treatment.

[FIG. 1]

100

[FIG. 2]

100

## INTERNATIONAL SEARCH REPORT

| International application No. |
| --- |
| **PCT/JP2024/010929** |

### A.   CLASSIFICATION OF SUBJECT MATTER

*H10N 30/30*(2023.01)i; *G01L 1/16*(2006.01)i
FI:   H10N30/30; G01L1/16 A; G01L1/16 C

According to International Patent Classification (IPC) or to both national classification and IPC

### B.   FIELDS SEARCHED

Minimum documentation searched (classification system followed by classification symbols)

H10N30/30; G01L1/16

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C.   DOCUMENTS CONSIDERED TO BE RELEVANT

| Category* | Citation of document, with indication, where appropriate, of the relevant passages | Relevant to claim No. |
| --- | --- | --- |
| Y | WO 2022/230622 A1 (KUREHA CORPORATION) 03 November 2022 (2022-11-03) paragraphs [0015], [0041], [0044], [0047], [0051], [0052], [0055] | 1-9 |
| Y | WO 2016/098597 A1 (MITSUI CHEMICALS, INC.) 23 June 2016 (2016-06-23) paragraphs [0014]-[0016], [0055], [0056], [0058], fig. 1 | 1-9 |
| Y | WO 2022/091828 A1 (KUREHA CORPORATION) 05 May 2022 (2022-05-05) paragraphs [0058], [0079], fig. 1-3 | 1-9 |

☐ Further documents are listed in the continuation of Box C.    ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **13 May 2024** | **28 May 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

International application No.

**PCT/JP2024/010929**

| Patent document cited in search report | | | Publication date (day/month/year) | Patent family member(s) | Publication date (day/month/year) |
|---|---|---|---|---|---|
| WO | 2022/230622 | A1 | 03 November 2022 | (Family: none) | |
| WO | 2016/098597 | A1 | 23 June 2016 | US 2018/0269377 A1<br>paragraphs [0048]-[0052],<br>[0150]-[0154], [0160]-[0163].<br>fig. 1<br>EP 3216596 A1 | |
| WO | 2022/091828 | A1 | 05 May 2022 | US 2023/0397500 A1<br>paragraphs [0062], [0083], fig.<br>1-3<br>EP 4238763 A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2016098597 A
- JP 2011006596 A
- WO 2020152464 A
- JP 2011222679 A
- JP 2023048026 A